Europäisches Patentamt

European Patent Office

Office européen des brevets

(11) Veröffentlichungsnummer: **0 059 342**
B1

(12) # EUROPÄISCHE PATENTSCHRIFT

(45) Veröffentlichungstag der Patentschrift:
08.08.84

(21) Anmeldenummer: 82100933.9

(22) Anmeldetag: 09.02.82

(51) Int. Cl.³: **C 08 F 8/50**, C 08 F 8/42,
H 01 B 1/12, H 01 L 29/28,
H 01 L 31/02, C 09 K 3/16

(54) Verfahren zur Herstellung von stabilen elektrisch leitfähigen Polymeren und deren Verwendung.

(30) Priorität: 18.02.81 DE 3105948

(43) Veröffentlichungstag der Anmeldung:
08.09.82 Patentblatt 82/36

(45) Bekanntmachung des Hinweises auf die Patenterteilung:
08.08.84 Patentblatt 84/32

(84) Benannte Vertragsstaaten:
BE DE FR GB NL

(73) Patentinhaber: BASF Aktiengesellschaft,
Carl-Bosch-Strasse 38, D-6700 Ludwigshafen (DE)

(72) Erfinder: Naarmann, Herbert, Dr., Haardtblick 15,
D-6719 Wattenheim (DE)
Erfinder: Penzien, Klaus, Dr., Bensheimer Ring 18,
D-6710 Frankenthal (DE)
Erfinder: Schlag, Johannes, Dr., Leuschnerstrasse 36,
D-6700 Ludwigshafen (DE)
Erfinder: Simak, Petr, Dr.,
Philipp-Scheidemann-Strasse 17, D-6700 Ludwigshafen
(DE)

(56) Entgegenhaltungen:
DE - A - 2 219 350

CHEMICAL ABSTRACTS, Band 70, Nr. 2, 1969, Seite 474,
Spalte 2, Nr. 4875g, Columbus, Ohio, USA L.
MORTILLARO: "Semiconducting organic polymers" &
MATER. PLAST. ELASTOMERI 1968, 34(8), 898-904

0 059 342

**Beschreibung**

Die Erfindung betrifft ein Verfahren zur Herstellung von stabilen elektrisch p-leitenden Polymeren mit elektrischen Leitfähigkeitswerten größer als $10^{-2}$ S/cm durch Dotieren von Polyacetylenen mit 15 bis 66 Gewichtsprozent, bezogen auf das Polyacetylen, eines Elektronenakzeptor-Dotierungsmittels sowie die Verwendung der so hergestellten leitfähigen Polymeren in der Elektrotechnik zur Herstellung und Fixierung von Strahlung, zur Herstellung elektrischer und magnetischer Schalter und Speicher und zur antistatischen Ausrüstung von Kunststoffen.

Es ist bekannt, elektrisch leitfähige Polymere herzustellen, indem man Polyacetylen mit Elektronenakzeptoren, insbesondere mit Lewis-Säuren, dotiert (vgl. z. B. US-PS 4 222 903 und »Synthetic Metals« 1, (1979/80) Seiten 101 bis 118).

Diese bekannten Systeme zeichnen sich durch eine gute elektrische Leitfähigkeit (p-Leiter) aus. Sie sind aber gegenüber Sauerstoff und Feuchtigkeit sehr empfindlich, so daß innerhalb von kurzer Zeit die elektrische Leitfähigkeit durch Oxydation oder durch Zersetzungsreaktion des Dotierungsmittels mit Wasser (Feuchtigkeit) drastisch abfällt. Ein technischer Einsatz derartiger Materialien ist daher nicht möglich.

Der Erfindung liegt die Aufgabe zugrunde, elektrisch leitfähige Polymere auf Polyacetylen-Basis zu schaffen, die neben einer hohen elektrischen Leitfähigkeit auch eine zufriedenstellende Stabilität gegenüber Luftsauerstoff und Feuchtigkeit aufweisen und aufgrund dieser Eigenschaftskombination anwendungstechnisches Interesse verdienen.

Diese Aufgabe wird erfindungsgemäß dadurch gelöst, daß p-dotierte Polyacetylene unter Ausschluß von Sauerstoff und Feuchtigkeit über eine Zeitdauer von 0,1 bis 3, bevorzugt 0,5 bis 1,0 Stunden auf Temperaturen zwischen 500 und 1100°C, bevorzugt im Bereich von etwa 550 bis 850°C erhitzt werden.

Unter stabilen elektrisch leitfähigen Polymeren mit elektrischen Leitfähigkeitswerten größer als $10^{-2}$ S/cm werden im Rahmen dieser Erfindung Stoffe verstanden, die gegenüber Luftsauerstoff und Feuchtigkeit bei Raumtemperatur stabil sind und keinen Abfall in der elektrischen Leitfähigkeit zeigen. Die elektrischen Leitfähigkeitswerte der Polymeren werden in S/cm bei 30°C gemessen, die Messung selbst erfolgt nach der Methode von F. Beck, Berichte Bunsengesellschaft, Physikalische Chemie 68, (1964), Seiten 558 bis 567.

Unter Polyacetylenen werden im Rahmen dieser Erfindung sowohl Polyacetylen selbst, d. h. $(CH)_x$, als auch Acetylen-Copolymere und substituierte Polyacetylene verstanden. Als Comonomere, welche zusammen mit Acetylen zu Copolymerisaten umgesetzt werden können, eignen sich insbesondere Di- und/oder Polyalkine, wie z. B. Butadiin, Hexadiin, Octadiin u. a. (vgl. z. B. DE-OS 2 912 572). Bei den substituierten Polyacetylenen ist wenigstens ein Teil der Wasserstoffatome an der Polymerkette durch Halogen insbesondere Cl, Br oder I, durch einen Alkylrest, insbesondere mit 1 bis 8 C-Atomen, durch einen Phenylrest, z. B. Phenyl, Halogenphenyl oder Alkylphenyl, oder durch mehrere dieser Gruppen substituiert. Die Polyacetylene, die durch Polymerisation der Monomeren mit Ziegler-Natta-Katalysatoren oder mit Hilfe von Reduktionsmitteln und Schwermetallsalzen, z. B. nach dem in der US-PS 3 092 613 beschriebenen Verfahren, hergestellt werden können, können dabei in beliebiger Form, z. B. in Form von Filmen, Folien, Preßfolien oder Pulvern eingesetzt werden.

Polyacetylene, die mit Elektronenakzeptoren zu p-Leitern dotiert sind, sind in der Literaturstelle »Synthetic Metals« 1 (1979/80) Seiten 101 bis 118 beschrieben. Die Herstellung von p-dotierten Polyacetylenen ist auch aus der US-PS 4 222 903 bekannt. Nach bekannten Methoden werden Polyacetylene durch Behandeln mit 15 bis 66, bevorzugt 20 bis 50 Gewichtsprozent, bezogen auf das Polyacetylen, eines Elektronenakzeptors dotiert, wodurch die Leitfähigkeit des betreffenden polymeren Systems (p-Leiter) deutlich gesteigert wird. Als Elektronenakzeptoren für die p-Dotierung der Polyacetylene kommen insbesondere Lewis-Säuren in Betracht, wie z. B.: $H_2SO_4$, $AsF_5$, $SbF_5$, $UF_6$, $SbCl_5$, $AlCl_3$, $BF_3$, $CF_3SO_3H$, $VOCl_3$, $HClO_4$, $NO^+SbF_6^-$, $NO_2^+SbF_6^-$, $NO^+AsF_6^-$, $NO^+PF_6^-$, $I_2$, $Br_2$, $ICl$, $PF_5$, $CrO_2Cl_2$, $NO_2^+PF_6^-$, $NO^+BF_4^-$, $NO^+ClO_4^-$, $(CF_3)_2SO_4$, $NbF_5$, $TaF_5$, $WF_6$, $FeCl_3$, $AlBr_3$, $CdCl_2$, 2,4,6-Trinitrophenol, 2,4,6-Trinitrophenylsulfonsäure oder 2,4,6-Trinitrobenzoesäure.

Nach dem erfindungsgemäßen Verfahren werden die in an sich bekannter Weise aus Polyacetylenen und Elektronenakzeptor-Dotierungsmitteln z. B. nach obigen Literaturstellen hergestellten p-dotierten Polyacetylene unter Ausschluß von Sauerstoff und Feuchtigkeit (Wasser) über einen Zeitraum von 0,1 bis 3, bevorzugt 0,5 bis 1,0 Stunden auf Temperaturen zwischen 500 und 1100°C, bevorzugt etwa 550 bis 850°C erhitzt. Zweckmäßig arbeitet man unter Edelgas-, z. B. Argonatmosphäre und erhitzt in Abwesenheit eines Lösungsmittels.

Nach dem erfindungsgemäßen Verfahren werden elektrisch leitfähige Polyacetylene mit elektrischen Leitfähigkeiten größer als $10^{-2}$ S/cm und verbesserter Stabilität gegenüber Sauerstoff und Feuchtigkeit erhalten, die zur antistatischen Ausrüstung von Kunststoffen, zur Herstellung von Sonnenzellen, zur Umwandlung und Fixierung von Strahlung sowie zur Herstellung elektrischer und magnetischer Schalter und Speicher geeignet sind.

Die in den folgenden Beispielen genannten Teile sind Gewichtsteile.

2

**0 059 342**

### Beispiele 1 bis 9

Verschiedene p-dotierte Polyacetylene, hergestellt entsprechend Beispiel 1 der US-PS 4 222 903, werden unter Argonatmosphäre und Ausschluß von Feuchtigkeit auf die nachfolgend angegebenen Temperaturen erhitzt, 1 Stunde bei den jeweiligen Temperaturen getempert und dann wieder abgekühlt. Die elektrischen Leitfähigkeiten der erhaltenen Polymeren, gemessen nach F. Beck, Berichte Bunsengesellschaft, Physikalische Chemie 68, (1964), Seiten 558 bis 567, bleiben selbst bei Lagerung der Proben an Luft über Tage erhalten.

| Beispiel Nr. | Polymer Typ 100 Tle. | Dotierungsmittel Menge (Teile) | Art | Tempertemperatur (°C) | Leitfähigkeit (S/cm) |
|---|---|---|---|---|---|
| 1 | + | 35 | $I_2$ | 650 | $1,5.10$ |
| 2 | + | 56 | $I_2$ | 650 | $2,3.10$ |
| 3 | + | 64 | $I_2$ | 650 | 4,8 |
| 4 | + | 28 | $AsF_5$ | 650 | $7,3.10$ |
| 5 | + + | 36 | $SbF_5$ | 720 | $2,3.10$ |
| 6 | + + | 48 | $NO^+SbF_6^-$ | 750 | $1,0.10^2$ |
| 7 | + + | 35 | $HClO_4$ | 820 (Zers.) | $3,9.10$ |
| 8 | + + | 53 | $H_2SO_4$ | 760 | 4,2 |
| 9 | + + | 49 | $AlBr_3$ | 750 | $3,9.10$ |

+) = Synthese nach Shirakawa, Journal Chemical Society, Chemical Communications 1977, Seiten 578 bis 580.

+ +) = Synthese nach Luttinger, US-PS 3 092 613.

### Patentansprüche

1. Verfahren zur Herstellung von stabilen elektrisch p-leitenden Polymeren mit elektrischen Leitfähigkeitswerten größer als $10^{-2}$ S/cm durch Dotieren von Polyacetylenen mit 15 bis 66 Gew.-%, bezogen auf das Polyacetylen, eines Elektronenakzeptor-Dotierungsmittels, dadurch gekennzeichnet, daß die p-dotierten Polyacetylene unter Ausschluß von Sauerstoff und Feuchtigkeit über eine Zeitdauer von 0,1 bis 3 Stunden auf Temperaturen zwischen 500 und 1100°C erhitzt werden.

2. Verfahren nach Anspruch 1, dadurch gekennzeichnet, daß 0,5 bis 1,0 Stunde erhitzt wird.

3. Verfahren nach Anspruch 1, dadurch gekennzeichnet, daß auf Temperaturen zwischen etwa 550 bis 850°C erhitzt wird.

4. Verwendung der nach Anspruch 1 hergestellten stabilen elektrisch leitfähigen polymeren Systeme in der Elektrotechnik zur Herstellung von Sonnenzellen, zur Umwandlung und Fixierung von Strahlung und zur Herstellung elektrischer und magnetischer Schalter und Speicher.

5. Verwendung der nach Anspruch 1 hergestellten stabilen elektrisch leitfähigen polymeren Systeme zur antistatischen Ausrüstung von Kunststoffen.

### Claims

1. A process for the preparation of stable electrically p-conductive polymers, having conductivities greater than $10^{-2}$ S/cm, by doping polyacetylenes with from 15 to 66 per cent by weight, based on polyacetylene, of an electron acceptor dopant, wherein the p-doped polyacetylenes are heated in the absence of oxygen and moisture for from 0.1 to 3 hours at from 500 to 1,100°C.

2. A process as claimed in claim 1, wherein heating is effected for from 0.5 to 1.0 hour.

3. A process as claimed in claim 1, wherein heating is effected at from about 550 to 850°C.

4. The use of the stable electrically conductive polymeric systems prepared as claimed in claim 1 in electrical engineering for the production of solar cells, the conversion and fixation of radiation, and the

3

0 059 342

production of electrical and magnetic switches and stores.

5. The use of the stable electrically conductive polymeric systems prepared as claimed in claim 1 for the antistatic finishing of plastics materials.

**Revendications**

1. Procédé de préparation de polymères conducteurs de l'électricité du type p stables, avec des conductibilités électriques supérieures à $10^{-2}$ S/cm, par dopage de poly-acétylènes avec 15 à 66% en poids par rapport au poly-acétylène d'un agent dopant accepteur d'électrons, caractérisé en ce que les poly-acétylènes dopés du type p sont maintenus pendant une durée de 0,1 à 3 heures, à l'abri de l'oxygène et de l'humidité, à des températures comprises entre 500 et 1100° C.

2. Procédé suivant la revendication 1, caractérisé en ce que la durée du chauffage est comprise entre 0,5 et 1,0 heure.

3. Procédé suivant la revendication 1, caractérisé en ce que les températures de chauffage sont comprises entre environ 550 et 850° C.

4. Utilisation des systèmes polymères conducteurs de l'électricité stables, préparés par le procédé de la revendication 1, dans le domaine de l'électro-technique pour la fabrication de cellules solaires, pour la fixation et la transformation de rayonnements et pour la fabrication de commutateurs et d'accumulateurs électriques et magnétiques.

5. Utilisation des systèmes polymères conducteurs de l'électricité stables, préparés par le procédé de la revendication 1, pour l'apprêtage antistatique de matières plastiques.

4